Europäisches Patentamt

(19) European Patent Office

Office européen des brevets

(11) Publication number: **0 103 280**
**B1**

(12) **EUROPEAN PATENT SPECIFICATION**

(45) Date of publication of patent specification: **28.12.88**

(51) Int. Cl.⁴: **G 03 F 1/00**

(21) Application number: **83108897.6**

(22) Date of filing: **08.09.83**

(54) Fabrication method of membrane structure.

(30) Priority: **10.09.82 JP 156844/82**

(43) Date of publication of application:
**21.03.84 Bulletin 84/12**

(45) Publication of the grant of the patent:
**28.12.88 Bulletin 88/52**

(84) Designated Contracting States:
**DE FR GB**

(56) References cited:
GB-A-2 076 587
US-A-4 284 678
JOURNAL OF THE ELECTROCHEMICAL
SOCIETY, Vol. 129, no. 3, March 1982, page
112c, no. 316, MANCHESTER, NEW
HAMPSHIRE, (US). K. SUZUKI et al. "X-Ray
Masks with High Aspect Ratio Submicron
Patterns Fabricated by Using Plasma-CVD SiN
Spacer and Membrane
JAPANESE J. APPLIED PHYSICS, Vol. 17, no. 9,
September 1979, pages 1693-1694, TOKYO,
(JP). H. YOSHIHARA et al.: "Preparation of Si-C
Films by Plasma Deposition Process with
Neutralization".

(73) Proprietor: **NIPPON TELEGRAPH AND
TELEPHONE CORPORATION**
**1-6 Uchisaiwaicho 1-chome Chiyoda-ku
Tokyo (JP)**

(72) Inventor: **Matsuo, Seitaro**
**861-1 Ishida, Isehara-shi
Kanagawa 259-11 (JP)**
Inventor: **Kiuchi, Mikiho**
**2-183 Sobudai, Zama-shi
Kanagawa 228 (JP)**
Inventor: **Sekimoto, Misao**
**1-14-4 Nakayashiki, Seya-ku Yokohama-shi
Kanagawa 246 (JP)**

(74) Representative: **Tiedtke, Harro, Dipl.-Ing. et al
Patentanwaltsbüro Tiedtke-Bühling-Kinne-
Grupe-Pellmann-Grams-Struif Bavariaring 4
Postfach 20 24 03
D-8000 München 2 (DE)**

Courier Press, Leamington Spa, England.

(56) References cited:
IBM TECHNICAL DISCLOSURE BULLETIN, Vol. 21, no. 10, March 1979, pages 4247-4248, NEW YORK, (US). A.N. BROERS et al.: "Reinforced membraneous substrates".

**Description**

The present invention relates generally to a process for fabricating a membrane structure and more particularly to a process for fabricating a membrane structure which is especially adapted for use as a mask substrate for X-ray lithography in which a fine pattern is transferred and exposed by using soft X-rays to form a pattern for the manufacture of electronic devices such as integrated semiconductor devices.

In a conventional process for fabricating a membrane structure, a thin film which becomes a membrane is first formed over one major surface of a substrate. Simultaneous with or after the formation of the thin film over one major surface of the substrate, a further thin film is formed over the other major surface of the substrate. Thereafter, the further thin film is removed by a suitable treatment. Like photo-etching except a portion which remains as a frame. Next, the substrate is removed except a portion which remains as a frame, by using an etchant which etches only the substrate, whereby a membrane structure is obtained.

Such membrane structure is used as a substrate for fabricating a mask for X-ray lithography. In this case, not only the membrane must have a high degree of transparency to X-rays, but also it must be sufficiently transparent over the whole wavelength range of visible light in order to use effectively an optical alignment apparatus which is used to align patterns with a high degree of precision when the patterns are transferred by using X-rays. The most fundamental requirement for such a membrane structure is that its membrane should be subjected to tension with a suitable tensile stress, so that it is prevented from sagging. Therefore, it is preferable that the membrane has a tensile stress from 5 kN/cm² to 30 kN/cm².

In order to fabricate a membrane consisting of an inorganic material, especially of a material such as silicon nitride ($Si_3N_4$), Chemical Vapor Deposition (CVD) process has widely been used in which a gas such as $SiH_2Cl_2$ or $NH_3$ is used as a raw material and the thermal reaction between $SiH_2Cl_2$ and $NH_3$ is utilized at a high temperature (700—900°C). When the CVD process is employed so as to form a $Si_3N_4$ film which becomes a membrane, the film generally has a high tensile stress (of the order of 100 kN/cm²). Therefore, M. Sekimoto et al. proposed that a thin film of silicon rich $SiN_x$ (x<4/3) is formed by controlling the reaction temperature and the composition of gases so that the tensile stress may be reduced [see "Silicon nitride single-layer X-ray mask", J. Vac. Sic. Technol. 21(4), Nov./Dec. 1982, pp. 1017—1021]. This process, however, has the defect that transparency to visible light, especially to light on the short wavelength side, is degraded considerably. Furthermore, it has disadvantages in that the stress cannot be controlled optimally and a high yield cannot be ensured.

From "Japanese J. Applied Physics", vol. 17, no. 9, September 1979, pages 1693—1694, a process for fabricating a membrane structure attempted to be used as a mask substrate for X-ray lithography is known. Said process comprises a first step of forming, by a plasma deposition process, a silicon carbide thin film which becomes a membrane over one surface of a substrate and a second step of removing a portion of said substrate by etching to provide a membrane and a frame supporting said membrane. The thin film thus formed has a high internal compressive stress disadvantageously causing a large deflection in the membrane obtained from the thin film by removing a portion of said substrate. It is further disclosed that in order to decrease said compressive stress, a high voltage must be applied. On application of a high voltage, however, electrification break occurred in these thin films causing pin holes to be formed by melting.

GB—A2 076 587 discloses a plasma deposition apparatus used for forming, by a plasma deposition process utilizing microwave electron cyclotron resonance, a thin film of e.g. silicon nitride over one surface of a substrate. Said GB—A describes on page 1, lines 124—127, a prior art plasma stream transport method for forming a thin film on a substrate wherein it was necessary to heat the substrate at 300 to 500°C so as to use a thermal reaction (i.e. thermal decomposition) of the plasma stream for forming the thin film.

It is the object of the present invention to provide a process for fabricating a membrane structure having a membrane which is highly transparent to visible light, whose internal stress can be optimally controlled and which is highly reliable and dependable in operation.

This object is according to the present invention achieved by a process for fabricating a membrane structure including the steps of:

(a) providing a substrate (1) having first and second surfaces;

(b) forming a thin film (2) over the first surface of said substrate (1); and

(c) removing a portion of said substrate (1) to provide said membrane and a frame (1A) supporting said membrane; wherein

(d) in step (b) said thin film (2) is formed by plasma deposition utilizing microwave electron cyclotron resonance generated by microwave power having a predetermined value; and

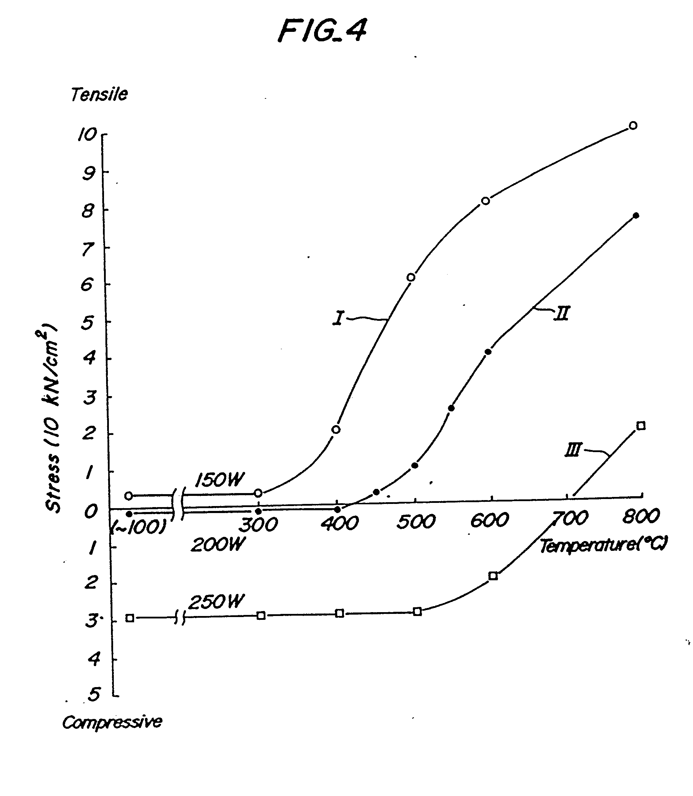

(e) after deposition of said thin film (2) said thin film (2) is heated to a temperature depending upon said predetermined value of microwave power in step (d) which temperature is as indicated in Fig. 4, whereby the internal stress of said thin film is controlled to a tensile stress value in the range of 5 to 30 kN/cm².

In a preferred embodiment of the process of the present invention, said step (c) further comprises:

a first sub-step of forming by e.g. plasma deposition utilizing microwave electron cyclotron resonance, a further thin film (3) over the second surface of said substrate; and

a second sub-step of removing a portion of said further thin film, the remaining portion of said further

thin film serving as a mask pattern for the formation of said frame, said removal of a portion of said substrate following said first and second sub-steps.

The portion of the substrate which remains as the frame may consist of a material having a low coefficient of thermal expansion and a high degree of dimensional accuracy, while the other portion of the substrate consists of a material which is easily dissolved away, and in said step (c), said other portion of said substrate is removed by a solvent.

Silicon nitride may be used as a material to form the thin film which becomes a membrane.

Further, an x-ray absorption pattern for x-ray lithography may be formed on said thin film which becomes a membrane on said substrate, whereby the thus obtained membrane is used as a mask for the X-ray litohgraphy.

Examples of the present invention are described in more detail with reference to the accompanying drawings, which illustrate only results of specific examples of the present invention, in which:

Figs. 1A through 1E are cross sections showing sequential steps for fabricating a membrane structure in accordance with the present invention;

Fig. 2 illustrates relationships of the deposition rate and the refractive index (n) to the microwave power used when $Si_3N_4$ films are formed by an ECR plasma deposition process;

Fig. 3 illustrates experimental results showing the relationship between the microwave power used and the stress, and in turn shows how stresses of silicon nitride films can be controlled in response to plasma deposition conditions; and

Fig. 4 illustrates experimental results showing the relationship between the heat treatment temperature and the stress, and in turn shows how stresses of silicon nitride films can be controlled in response to the heat treatment temperature.

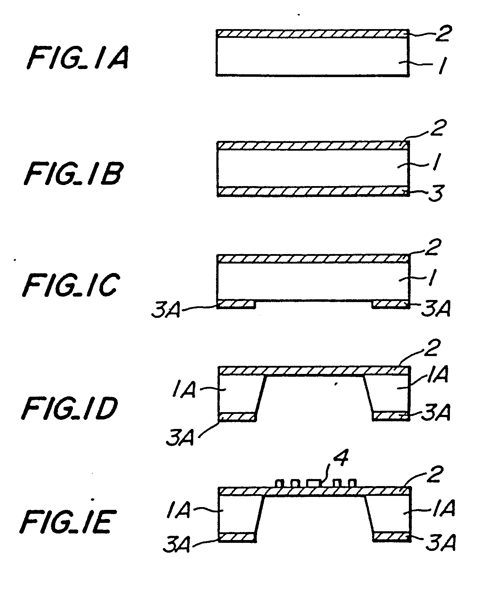

Fig. 1A through Fig. 1E show one example of steps for fabricating a membrane structure in accordance with the present invention. As shown in Fig 1A, as a substrate 1 use was made of a (100) silicon wafter having a diameter of 50.8 or 76.2 mm and having a thickness of 0.4 mm. A thin film 2 which becomes a membrane, of $Si_3N_4$ having a thickness of 0.5—2 µm was deposited on the surface of the substrate 1 by an ECR (electron cyclotron resonance) plasma deposition process. The apparatus used for the ECR plasma deposition process is disclosed in detail in JP—A—155 535/1981. In the deposition process, the $Si_3N_4$ film was formed by using $N_2$ and $SiH_4$ gases at a low temperature without heating the substrate 1.

The composition and internal stress of the $Si_3N_4$ film 2 can be controlled over a wide range by changing the conditions of the ECR plasma deposition process such as flow rates of gases, gas pressures, microwave power and the like. Thus, by controlling such deposition conditions as described above, the deposited $Si_3N_4$ film may have a stoichiometric composition of $Si_3N_4$, and while a high degree of transparency is maintained the deposited film has various stress conditions, i.e., the film may have a compressive strength, may be free of stress or may have a weak tensile stress, without heating in the deposition step. Here, a weak tensile stress satisfies the conditions of membrane.

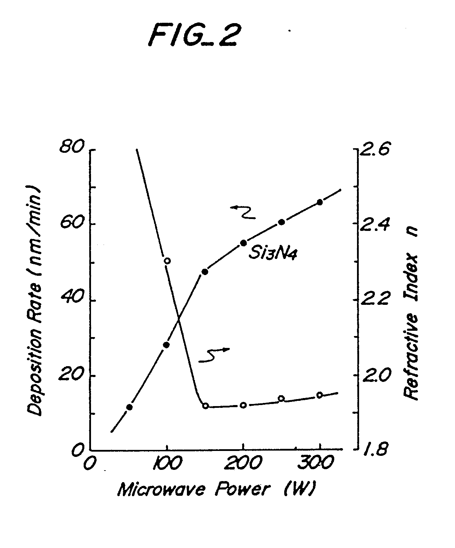

Fig. 2 illustrates the relationships between the microwave power on the one hand and the deposition rate and the refractive index on the other hand. In the experiments, the gas introduction conditions are as follows: the flow rate of $N_2$ was 30 cm³/min; the flow rate of $SiH_4$ was 20 cm³/min; and the gas pressure was maintained at 67 mPa. Even with the high microwave power of more than 150 W, films with a high degree of transparency and a substantially constant refractive index (n=1.9—2.0) were obtained.

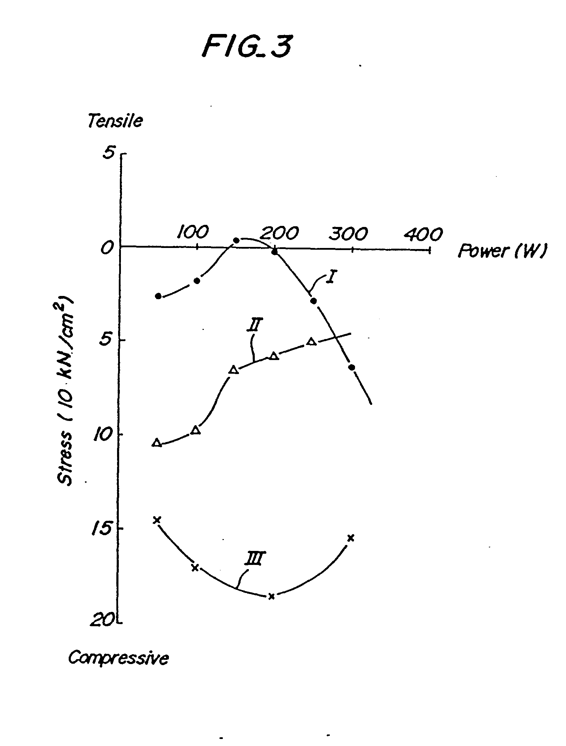

As shown by the characteristic curve I in Fig. 3, when the power was 150 W, the film had a weak tensile stress; when the power was 200 W, the film was free from stress; and when the power was higher than 200 W, the film has compressive stresses. In case of the power of 200 W at which the film has no stress, the deposition rate was 55.0 nm/min, so that the film can be deposited in a very efficient manner. The thus obtained $Si_3N_4$ films were very dense and the etch rate was less than 8.0 nm/min when a buffer hydrofluoric acid solution (50% HF: 40% $NH_4F$=15:85, at 20°C) was used. The etch rate was substantially the same as in the case when $Si_3N_4$ films were formed at a high temperature of 800°C by CVD.

Fig. 3 also illustrates the relationship between the microwave power and the stress when plasma deposition conditions such as gas flow rates and gas pressure were varied. The substrate was not heated. The characteristic curves I, II and III as shown in Fig. 3 are obtained under the following conditions:

| Characteristic curve | Gas introduction conditions | | |
|---|---|---|---|
| | $N_2$ (cm³/min) | $SiH_4$ (cm³/min) | Gas pressure |
| I | 30 | 20 | 67 mPa |
| II | 15 | 10 | 40 mPa |
| III | 10 | 10 | 27 mPa |

When a prior art high-temperature CVD method is employed, a film with a high degree of tensile stress is obtained, but when the ECR plasma process in accordance with the present invention is used, films may have compressive stresses as shown in Fig. 3. The stresses of the films were especially influenced by the gas pressure, and the least stress was obtained when the gas pressure was about 67 mPa. When the gas pressure was in excess of 67 mPa, for instance, about 133 mPa, the density of the film was degraded. That is, a film with a high density was not obtained without heating the substrate.

In the step shown in Fig. 1B, a $Si_3N_4$ film 3 having a thickness of 0.2—0.5 mm was deposited on the substrate 1 by the ECR plasma deposition process under the same conditions as described above.

The thin film 2 thus deposited was subjected to a heat treatment, so that its tensile stress can be controlled with a high degree of accuracy. Fig. 4 illustrates the relationship between the heat treatment temperature and the stress of the $Si_3N_4$ film which was deposited under the following deposition conditions, when the heat treatment was carried out for 30 minutes in vacuum after deposition. The deposition conditions were that the substrate was not heated, that the gas introduction conditions were as follows: $N_2$ was introduced at the rate of 30 $cm^3$/min and $SiH_4$ at the rate of 20 $cm^3$/min, and that the gas pressure was maintained at 67 mPa. Characteristic curves I, II and III were obtained, when the microwave powers are 150, 200 and 250 W, respectively.

As indicated by the characteristic curve I, there was no variation in stress up to 300°C when the power was 150 W, but a stress increased on the side of tensile stress when the heat treatment temperature exceeded 300°C. As indicated by the characteristic curve II, there was no substantial variation in stress up to 400°C when the microwave power was 200 W, but the stress gradually increased from the compressive side to the tensile side, when the heat treatment temperature increased beyond 400°C and it increased almost linearly when the heat treatment temperature increased beyond 600°C. As indicated by the characteristic curve III, there was no variation in stress up to 500°C, but if the heat temperature exceeded 500°C, the stress changed toward tensile stress.

As described above, by suitably selecting the conditions of heat treatment, the internal stress of a $Si_3N_4$ film can be controlled with a high degree of accuracy to a desired tensile stress value within the preferable range between 5 $kN/cm^2$ and 30 $kN/cm^2$. For instance, in order to obtain a tensile stress of 10 $kN/cm^2$, the film is heat treated at 360°C with the microwave power of 150 W or at 500°C with the microwave power of 200 W or at 750°C with the microwave power of 250 W. Instead of the heat treatment in vacuum, the heat treatment can easily be carried out in an atmosphere of $N_2$ or air, since the $Si_3N_4$ film is very stable.

The step for deposition of a thin film and the step for heat treating the thin film are carried out independently, so that the control flexibility can be improved and reliability in treatment can be increased.

In the step shown in Fig. 1C, except the portion of the $Si_3N_4$ film 3A which remains as a mask pattern for the formation of a frame, the $Si_3N_4$ film 3 was removed. To this end, a photo patterning was applied to the film 3 and then the film 3 was etched by reactive sputter etching with a $C_2F_6$ gas. As a result, except the frame portion 3A, the film 3 was easily removed as shown in Fig. 1C.

Thereafter, in the step shown in Fig. 1D, the silicon substrate 1 was etched with, e.g., 20% KOH solution heated at 100°C, with the $Si_3N_4$ film 3A being used as a mask. Consequently, the portion 1A which serves as a frame remained as shown in Fig. 1D, so that a membrane structure with the membrane 2 and the frame portions 1A and 3A was obtained as shown in Fig. 1D.

By the steps 1A through 1D, a $Si_3N_4$ membrane having a thickness of 0.5—2 μm and an area of 20×20 mm was obtained with a high yield.

The thus obtained membrane was highly transparent to visible light, and the wavelength of light transmitted through the membrane extended to 320.0 nm; i.e., the ultraviolet region. While in the above example, the substrate 1 has been described as consisting of silicon, it is to be understood that the substrate 1 may be made of other materials.

According to the present invention, the $Si_3N_4$ film 2 which becomes a membrane is formed at a low temperature (less than 100°C or so) without heating the substrate 1, so that a material which has a relatively low degree of resistance to heat can be advantageously used as a substrate.

For instance, the frame portion 1A of the substrate 1 may consist of a material such as quartz glass having a low coefficient of thermal expansion and a high degree of dimensional accuracy, while the other portion which is to be removed by etching or the like may consist of an organic material or a salt which is easily dissolved away. In this case, after the thin film 2 which becomes a membrane is formed over the entire surface of the substrate 1 at a low temperature, except the frame portion 1A of the substrate 1, the substrate 1 is removed with a suitable etchant, whereby the membrane is formed. Thereafter, in order to control the stress of the membrane, the membrane may be subjected to the heat treatment as described above.

In addition to $Si_3N_4$, a material with a low X-ray absorption coefficient such as BN (boron nitride) or SiC (silicon carbide) may be used as a material of the thin film 2. In this case, two independent stress control steps or conditions; that is, conditions for plasma deposition and heat treatment can be employed in order to provide an optimum stress to said film.

In the case of the fabrication of a mask for use in X-ray lithography, a material with a high atomic weight and a high X-ray absorption coefficient such as Au, Pt, W or Ta is used to form an X-ray absorption pattern 4 as shown in Fig. 1E.

This step for forming an X-ray absorption pattern may be carried out after the step as shown in Fig. 1B or 1C.

As described above, according to the present invention, a thin film with a high density and a high quality can be formed at a low temperature by utilizing a plasma produced by the electron cyclotron resonance of microwave and the internal stress of the thin film which becomes a membrane can be controlled by varying the plasma deposition conditions, so that a membrane structure can be formed. Furthermore, a membrane structure can be manufactured in such a way that the internal stress of the thin film is controlled to a desired tensile stress value with a high degree of accuracy by heating treating the thin film after the deposition of the thin film. Therefore, according to the present invention, a membrane consisting of a thin $Si_3N_4$ film with an extremely high degree of transparency to light and a high quality can be fabricated with a high yield. In addition, according to the present invention, a thin film which becomes a membrane is formed at a low temperature, so that a substrate with a relatively low resistance to heat can be used. Thus, the steps of the fabrication of a membrane structure are much facilitated.

According to the present invention, a $Si_3N_4$ membrane which is highly transparent to visible light can be obtained. The membrane structure can be used as a mask in X-ray lithography, so that the patterns can be aligned with a high degree of accuracy in the case of pattern transfer by using an optical alignment apparatus.

Moreover, according to the present invention, the process can be carried out at a low temperature, so that the fabrication time can be shortened and a high yield can be ensured. In addition, since substrates with a low resistance to heat can be used, the fabrication process can be considerably improved.

The membrane structure thus fabricated in accordance with the present invention can advantageously be used as an X-ray extraction aperture or window for extracting X-rays from vacuum into the air atmosphere in an X-ray lithography apparatus.

## Claims

1. A process for fabricating a membrane structure including the steps of:

(a) providing a substrate (1) having first and second surfaces;

(b) forming a thin film (2) over the first surface of said substrate (1); and

(c) removing a portion of said substrate (1) to provide said membrane and a frame (1A) supporting said membrane; characterized in that

(d) in step (b) said thin film (2) is formed by plasma deposition utilizing microwave electron cyclotron resonance generated by microwave power having a predetermined value; and

(e) after deposition of said thin film (2) said thin film (2) is heated to a temperature depending upon said predetermined value of microwave power in step (d) which temperature is as indicated in Fig. 4, whereby the internal stress of said thin film is controlled to a tensile stress value in the range of 5 to 30 $kN/cm^2$.

2. A process as claimed in claim 1, characterized in that said thin film is a silicon nitride film and that in said step (e) the temperature to which said thin film is heated is at least 300°C when said microwave power is 150 W (curve I in Fig. 4), at least 400°C when said microwave power is 200 W (curve II), and at lea/t 700°C when said microwave power is 250 W (curve III).

3. A process as claimed in claim 1, characterized in that the portion of said substrate comprising said frame consists of a material having a low coefficient of thermal expansion and a high degree of dimensional accuracy, the other portion of said substrate comprising an easily dissolvable material, and in said step (c) the portion of said substrate removed is dissolved by a solvent.

4. A process as claimed in claim 1, characterized in that said step (c) further comprises:

a first sub-step of forming a further thin film (3) over the second surface of said substrate; and

a second sub-step of removing a portion of said further thin film, the remaining portion of said further thin film serving as a mask pattern for the formation of said frame, said removal of a portion of said substrate following said first and second sub-steps.

5. A process as claimed in claim 4, characterized in that an X-ray absorption pattern for X-ray lithography is formed on said thin film, whereby the thus obtained membrane is used as a mask for said X-ray lithography.

6. A process as claimed in claim 5, characterized in that said X-ray absorption pattern is formed after said step (c).

## Patentansprüche

1. Verfahren zur Herstellung einer Membranstruktur mit den folgenden Schritten:

(a) Bereitstellung eines Substrats (1) mit einer ersten und einer zweiten Oberfläche,

(b) Bildung eines Dünnfilms (2) über der ersten Oberfläche des erwähnten Substrats (1) und

(c) Entfernung eines Teils des erwähnten Substrats (1), um die erwähnte Membran und einen die erwähnte Membran tragenden Rahmen (1A) bereitzustellen, dadurch gekennzeichnet, daß

(d) der erwähnte Dünnfilm (2) in Schritt (b) durch Plasmaabscheidung unter Ausnutzung von Mikrowellen - Elektronenzyklotronresonanz, die durch Mikrowellenleistung mit einem festgelegten Wert erzeugt wird, gebildet wird und

(e) der erwähnte Dünnfilm (2) nach Abscheidung des erwähnten Dünnfilms (2) auf eine Temperatur erhitzt wird, die von dem erwähnten festgelegten Wert der Mikrowellenleistung in Schritt (d) abhängt, wobei diese Temperatur einen Wert hat, wie er in Fig. 4 gezeigt ist, wodurch die innere Spannung des erwähnten Dünnfilms auf einen Zugspannungswert von 5 bis 30 kN/cm$^2$ eingestellt wird.

2. Verfahren nach Anspruch 1, dadurch gekennzeichnet, daß der erwähnte Dünnfilm ein Siliciumnitridfilm ist und daß in dem erwähnten Schritt (e) die Temperatur, auf die der erwähnte Dünnfilm erhitzt wird, mindestens 300°C beträgt, wenn die erwähnte Mikrowellenleistung 150 W beträgt, (Kurve I in Fig. 4), mindestens 400°C beträgt, wenn die erwähnte Mikrowellenleistung 200 W beträgt, (Kurve II) und mindestens 700°C beträgt, wenn die erwähnte Mikrowellenleistung 250 W beträgt, (Kurve III).

3. Verfahren nach Anspruch 1, dadurch gekennzeichnet, daß der Teil des erwähnten Substrats, der den erwähnten Rahmen bildet, aus einem Material mit einem niedrigen Wärmeausdehnungskoeffizienten und einem hoher Maßgenauigkeitsgrad besteht, wobei der andere Teil des erwähnten Substrats aus einem leicht löslichen Material besteht, und daß in dem erwähnten Schritt (c) der Teil des erwähnten Substrats, der entfernt wird, durch ein Lösungsmittel aufgelöst wird.

4. Verfahren nach Anspruch 1, dadurch gekennzeichnet, daß der erwähnte Schritt (c) ferner einen ersten Unterschritt zur Bildung eines weiteren Dünnfilms (3) übe der zweiten Oberfläche des erwähnten Substrats und einen zweiten Unterschritt zur Entfernung eines Teils des erwähnten weiteren Dünnfilms umfaßt, wobei der verbleibende Teil des erwähnten weiteren Dünnfilms als Maskenmuster für die Bildung des erwähnten Rahmens dient und wobei die erwähnte Entfernung eines Teils des erwähnten Substrats auf den erwähnten ersten und zweiten Unterschritt folgt.

5. Verfahren nach Anspruch 4, dadurch gekennzeichnet, daß auf dem erwähnten Dünnfilm ein Röntgenabsorptionsmuster für die Röntgenlithographie gebildet wird, wodurch die auf diese Weise erhaltene Membran als Maske für die erwähnte Röntgenlithographie verwendet wird.

6. Verfahren nach Anspruch 5, dadurch gekennzeichnet, daß das erwähnte Röntgenabsorptionsmuster nach dem erwähnten Schritt (c) gebildet wird.

**Revendications**

1. Un procédé de fabrication d'une structure de membrane comprenant les étapes suivantes:
(a) on fournit un substrat (1) ayant des première et seconde surfaces;
(b) on forme une pellicule mince (2) sur la première surface de ce substrat (1); et
(c) on enlève une partie du substrat (1) pour définir la membrane et un cadre (1A) supportant la membrane; caractérisé en ce que
(d) dans l'étape (b), on forme la pellicule mince (2) par dépôt par plasma et utilisant une résonance cyclotron d'électrons en micro-ondes, générée par de la puissance micro-onde ayant une valeur prédéterminée; et
(e) après le dépôt de la pellicule mince (2), on chauffe la pellicule mince (2) jusqu'à une température qui dépend de la valeur prédéterminée de la puissance micro-onde dans l'étape (d), cette température correspondant à ce qu'indique la figure 4, grâce à quoi la contrainte interne de la pellicule mince est définie de façon à avoir une valeur de contrainte de traction dans la plage de 5 à 30 kN/cm$^2$.

2. Un procédé selon la revendication 1, caractérisé en ce que la pellicule mince est une pellicule de nitrure de silicium et en ce qu'à l'étape (e), la température à laquelle la pellicule mince est chauffée est d'au moins 300°C lorsque la puissance micro-onde est de 150 W (courbe I sur la figure 4), d'au moins 400°C lorsque la puissance micro-onde est de 200 W (courbe II), et d'au moins 700°C lorsque la puissance micro-onde est de 250 W (courbe III).

3. Un procédé selon la revendication 1, caractérisé en ce que la partie du substrat qui constitue la cadre consiste en un matériau ayant un faible coefficient de dilation thermique et un degré élevé de précision dimensionnelle, l'autre partie du substrat consistant en un matériau qu'on peut dissoudre aisément, et en ce que dans l'étape (c), on dissout au moyen d'un solvant la partie du substrat à enlever.

4. Un procédé selon la revendication 1, caractérisé en ce que l'étape (c) comprend en outre:
une première sous-étape consistant à former une pellicule mince supplémentaire (3) sur la second surface du substrat; et
une second sous-étape consistant à enlever une partie de cette pellicule mince supplémentaire, la partie restante de la pellciule mince supplémentaire faisant fonction de motif de masque pour la formation du cadre, et l'énlèvement d'une partie du substrat faisant suite aux première et seconde sous-étapes.

5. Un procédé selon la revendication 4, caractérisé en ce qu'on forme sur la pelliciule mince un motif d'absorption de rayons X, pour la lithographie par rayons X, grâce à quoi la membrane ainsi obtenue est utilisée en tant que masque pour la lithographie par rayons X.

6. Un procédé selon la revendication 5, caractérisé en ce qu'on forme le motif d'absorption de rayons X après l'étape (c).

FIG.1A

FIG.1B

FIG.1C

FIG.1D

FIG.1E

## FIG_2

# FIG_3

FIG.4